# EUROPÄISCHE PATENTSCHRIFT

(11) **EP 4 430 920 B1**
(45) Veröffentlichungstag und Bekanntmachung des Hinweises auf die Patenterteilung: **21.05.2025**
(21) Anmeldenummer: 22817233.4
(22) Anmeldetag: 11.11.2022
(51) Int. Cl.: H05B 6/68, H05B 6/80, H05B 6/70

(54) **VERFAHREN UND VORRICHTUNG ZUM ERHITZEN EINES MEDIUMS UNTER VERWENDUNG EINES HF-SIGNALS**
METHOD AND APPARATUS FOR HEATING A MEDIUM USING AN HF SIGNAL
PROCÉDÉ ET DISPOSITIF POUR CHAUFFER UN FLUIDE EN UTILISANT UN SIGNAL HF

(30) Priorität: 12.11.2021 DE 102021129565
(43) Veröffentlichungstag der Anmeldung: 18.09.2024
(73) Patentinhaber: TRUMPF Hüttinger GmbH + Co. KG, 79111 Freiburg (DE)
(72) Erfinder: WASSENBERG, Sebastian, 75038 Oberderdingen (DE); TRABER, Thomas, 82064 Strasslach-Dinghartingen (DE)
(74) Vertreter: Trumpf Patentabteilung
(86) Internationale Anmeldenummer: PCT/EP2022/081638
(87) Internationale Veröffentlichungsnummer: WO 2023/084033

(56) Entgegenhaltungen:
- US-A1- 2012 152 940
- US-A1- 2018 151 332
- US-A1- 2019 080 886

## Beschreibung

Die vorliegende Erfindung betrifft ein Verfahren zum Erhitzen eines Mediums, insbesondere zum Erzeugen eines Plasmas, unter Verwendung eines HF-Signals mit den Schritten
- Erzeugen eines HF-Speisesignals mit einer definierten ersten Betriebsfrequenz und einer definierten ersten Signalleistung, insbesondere mittels eines HF-Generators,
- Einkoppeln des HF-Speisesignals in das Medium über eine Übertragungsstrecke, so dass das Medium durch das HF-Speisesignal aufgeheizt wird,
- Bestimmen einer ersten HF-Signalreflexion entlang der Übertragungsstrecke, insbesondere mittels einer Mess- und Steuereinrichtung, und

- Verändern der ersten Betriebsfrequenz in Abhängigkeit von der ersten HF-Signalreflexion, um zeitlich nachfolgende HF-Signalreflexionen zu reduzieren, insbesondere mittels der Mess- und Steuereinrichtung.

Die Erfindung betrifft außerdem eine Vorrichtung zum Erhitzen eines Mediums, insbesondere zum Erzeugen eines Plasmas, unter Verwendung eines HF-Signals
- mit einem HF-Generator, der dazu eingerichtet ist, ein HF-Speisesignal mit einer definierten ersten Betriebsfrequenz und einer definierten ersten Signalleistung zu erzeugen,
- mit einer Übertragungsstrecke, die dazu eingerichtet ist, das HF-Speisesignal in das Medium einzukoppeln, so dass das Medium durch das HF-Speisesignal aufgeheizt werden kann, und
- mit einer Mess- und Steuereinrichtung, die dazu eingerichtet ist, eine erste HF-Signalreflexion entlang der Übertragungsstrecke zu bestimmen, und
- die ferner dazu eingerichtet ist, die erste Betriebsfrequenz in Abhängigkeit von der ersten HF-Signalreflexion zu verändern, um zeitlich nachfolgende HF-Signalreflexionen zu reduzieren.

Ein solches Verfahren und eine entsprechende Vorrichtung sind beispielsweise aus US 2014/0197761 A1 bekannt.

Die bekannte Vorrichtung kann u.a. verwendet werden, um ein Plasma zu erzeugen, das in Ätz- und/oder Beschichtungsanlagen zur Oberflächenbearbeitung von Werkstücken dient. Als Plasma wird hier ein Gas verstanden, das durch Energieaufnahme (Aufheizen) von außen in einen angeregten Zustand gebracht wird, so dass Ladungsträger des Gases aus ihren jeweiligen atomaren und/oder molekularen Bindungen herausgelöst werden und als freie Ladungsträger vorhanden sind. Infolgedessen besitzt das Plasma eine elektrische Leitfähigkeit, die von der Anzahl der freien Ladungsträger und damit von der jeweiligen Energieaufnahme abhängt. Charakteristisch für eine Vorrichtung zur Erzeugung eines Plasmas ist, dass sich die Impedanz der Last, d.h. in diesem Fall die Impedanz der mit der Heizenergie zu versorgenden Plasmakammer, sehr schnell und stark verändern kann. Dies stellt hohe Anforderungen an den HF-Generator, der das elektrische HF-Signal zum Aufheizen des Gases und zum Versorgen des Plasmas mit elektrischer Leistung erzeugt, und an die Übertragungsstrecke, weil die Einkopplung des elektrischen Heizsignals davon abhängt, wie gut die Ausgangsimpedanz des Generators an die Eingangsimpedanz der Last angepasst ist. Jede Fehlanpassung führt zu Reflexionen mit der Folge, dass ein Teil oder im ungünstigsten Fall sogar die gesamte elektrische Leistung nicht in das aufzuheizende Gas bzw. Plasma gelangt, sondern zu dem Ausgang des Generators reflektiert wird. Dies kann ohne geeignete Gegenmaßnahmen zur Zerstörung des Generators und/oder anderer Komponenten einer solchen Vorrichtung führen. Außerdem kann das Plasma erlöschen, wenn nicht mehr genügend Heizleistung in das Gas gelangt.

In US 2018/0151332 A1 ist eine Plasmaverarbeitungsvorrichtung offenbart, die eine Mikrowellenausgangseinheit, eine Wellenleiterröhre, einen Tuner, eine Demodulationseinheit und eine Berechnungseinheit umfasst. Die Mikrowellenausgabeeinheit gibt eine Mikrowelle mit einer Leistung aus, die der Einstellleistung entspricht, während die Mikrowelle in einem Einstellfrequenzbereich frequenzmoduliert wird. Das Wellenleiterrohr führt die Mikrowelle zu einer Antenne eines Kammerhauptkörpers. Das Stimmgerät ist im Wellenleiterrohr vorgesehen und stellt die Position einer beweglichen Platte ein. Die Demodulationseinheit ist in der Wellenleiterröhre vorgesehen und erfasst für jede Frequenz Wanderwellenleistung und reflektierte Wellenleistung. Die Berechnungseinheit berechnet eine Frequenz, bei der ein Reflexionskoeffizient, der auf der Grundlage der Wanderwellenleistung und der reflektierten Wellenleistung berechnet wird, für jede Frequenz zu einem Mindestpunkt als Absorptionsfrequenz wird.

In US 2012/0152940 A1 ist eine Mikrowellenheizvorrichtung offenbart. Dort führt ein Steuerteil eine Operation zum abwechselnden Wiederholen eines Sweeping-Vorgangs zum Erfassen reflektierter elektrischer Leistung mit einem elektrischen Leistungsdetektionsabschnitt durch, während eine Schwingungsfrequenz eines Schwingungsabschnitts geändert und ein Phasenwert eines phasenvariablen Abschnitts zum Erfassen einer reflektierten elektrischen Leistungscharakteristik in Bezug auf den Schwingungsabschnitt festgelegt wird, und eine Sweeping-Operation zum Erfassen reflektierter elektrischer Leistung mit dem elektrischen Leistungsdetektionsteil unter Änderung des Phasenwerts des phasenvariablen Teils und Festlegen der Schwingungsfrequenz des Schwingungsabschnitts zum Erkennen einer reflektierten elektrischen Leistungskennlinie in Bezug auf den Phasenwert, um eine Schwingungsfrequenz und einen Phasenwert zur Verwendung bei der Erwärmung eines zu erwärmenden Objekts zu bestimmen.

In US 2019/0080886 A1 ist ein Mikrowellen-Erzeugungssystem offenbart. Dieses umfasst eine modulare Architektur, die konfigurierbar ist, um eine Leistung von unter 1 kW bis über 100 kW zu liefern. Die verschiedenen Leistungsstufen werden durch die Kombination der HF-Ausgänge mehrerer HF-Leistungsverstärker in einer Unternehmensstruktur erreicht. Jede Systemkomponente enthält einen dedizierten eingebetteten Mikrocontroller für eine leistungsstarke Echtzeit-Steuerungsreaktion. Die Komponenten sind mit einem digitalen Hochgeschwindigkeits-Datenbus verbunden und werden von einem Steuerungsprogramm gesteuert und überwacht, das auf einem Host-Computer ausgeführt wird.

Die vorliegende Erfindung ist nicht auf Vorrichtungen und Verfahren zum Erzeugen eines Plasmas beschränkt, wenngleich dies eine bevorzugte Anwendung ist. Das beschriebene Verfahren und die beschriebene Vorrichtung können gleichermaßen auch zum Aufheizen von anderen Medien und/oder zu anderen Zwecken verwendet werden, etwa zum Aufheizen von flüssigen oder festen Medien.

Die bekannten Verfahren zur Anpassung der Betriebsfrequenz eines HF-Signalgenerators, der zum Aufheizen eines Mediums verwendet wird, sind vergleichsweise aufwändig zu implementieren. Außerdem benötigt die Suche nach der jeweils optimalen Betriebsfrequenz in einigen Implementierungen recht viel Zeit. Es ist daher eine Aufgabe der vorliegenden Erfindung, ein Verfahren und eine Vorrichtung der eingangs genannten Art anzugeben, mit denen eine geeignete Betriebsfrequenz des HF-Signalgenerators relativ einfach und schnell eingestellt werden kann.

Gemäß einem Aspekt der vorliegenden Erfindung wird diese Aufgabe durch ein Verfahren nach Anspruch 1 und/oder eine Vorrichtung nach Anspruch 14 gelöst. Bevorzugte Ausgestaltungen des Verfahrens und/oder der Vorrichtung sind in den Unteransprüchen und der Beschreibung beschrieben. Demnach wird diese Aufgabe durch ein Verfahren der eingangs genannten Art gelöst, wobei die definierte erste Betriebsfrequenz während eines ersten Testintervalls um einen definierten ersten Frequenzwert verändert, insbesondere erhöht, wird, um das erste HF-Speisesignal zeitlich begrenzt mit einer veränderten, insbesondere erhöhten, ersten Betriebsfrequenz in das Medium einzukoppeln, und wobei die definierte erste Betriebsfrequenz während eines zweiten Testintervalls um einen definierten zweiten Frequenzwert in umgekehrter Weise verändert, insbesondere reduziert, wird, um das erste HF-Speisesignal zeitlich begrenzt mit einer in umgekehrter Weise veränderten, insbesondere reduzierten ersten Betriebsfrequenz in das Medium einzukoppeln, wobei während des ersten Testintervalls eine zweite HF-Signalreflexion bestimmt wird, die zeitlich mit der veränderten, insbesondere erhöhten, ersten Betriebsfrequenz korreliert, und wobei während des zweiten Testintervalls eine dritte HF-Signalreflexion bestimmt wird, die zeitlich mit der in umgekehrter Weise veränderten, insbesondere reduzierten, ersten Betriebsfrequenz korreliert, und wobei das HF-Speisesignal nach Ablauf des zweiten Testintervalls mit einer definierten zweiten Betriebsfrequenz erzeugt und in das Medium eingekoppelt wird, wobei die definierte zweite Betriebsfrequenz in Abhängigkeit von der ersten, zweiten und dritten HF-Signalreflexion ausgewählt wird, insbesondere aus der ersten Betriebsfrequenz, der in umgekehrter Weise veränderten, insbesondere reduzierten ersten Betriebsfrequenz und der veränderten, insbesondere erhöhten ersten Betriebsfrequenz.

Gemäß einem weiteren Aspekt wird diese Aufgabe durch eine Vorrichtung der eingangs genannten Art gelöst, wobei die Mess- und Steuereinrichtung ferner dazu eingerichtet ist, die definierte erste Betriebsfrequenz während eines ersten Testintervalls um einen definierten ersten Frequenzwert zu verändern, insbesondere zu erhöhen, um das erste HF-Speisesignal zeitlich begrenzt mit einer veränderten, insbesondere erhöhten, ersten Betriebsfrequenz in das Medium einzukoppeln, ferner die definierte erste Betriebsfrequenz während eines zweiten Testintervalls um einen definierten zweiten Frequenzwert in umgekehrter Weise zu verändern, insbesondere zu reduzieren, um das erste HF-Speisesignal zeitlich begrenzt mit einer in umgekehrter Weise veränderten, insbesondere reduzierten, ersten Betriebsfrequenz in das Medium einzukoppeln, ferner während des ersten Testintervalls eine zweite HF-Signalreflexion zu bestimmen, die zeitlich mit der veränderten, insbesondere erhöhten ersten Betriebsfrequenz korreliert, ferner während des zweiten Testintervalls eine dritte HF-Signalreflexion zu bestimmen, die zeitlich mit der in umgekehrter Weise veränderten, insbesondere reduzierten, ersten Betriebsfrequenz korreliert, und das HF-Speisesignal nach Ablauf des zweiten Testintervalls mit einer definierten zweiten Betriebsfrequenz zu erzeugen und in das Medium einzukoppeln, wobei die definierte zweite Betriebsfrequenz in Abhängigkeit von der ersten, zweiten und dritten HF-Signalreflexion, insbesondere aus der ersten Betriebsfrequenz, der veränderten, insbesondere erhöhten ersten Betriebsfrequenz und der in umgekehrter Weise veränderten, insbesondere reduzierten ersten Betriebsfrequenz ausgewählt ist.

Die beschriebene Vorrichtung und das beschriebene Verfahren lassen sich sehr einfach implementieren, insbesondere wenn der HF-Signalgenerator ein sogenannter Solid State Generator mit einem spannungsgesteuerten Oszillator (VCO) und/oder einer Phasenregelschleife (Phase Locked Loop, PLL) ist. Ein solcher HF-Signalgenerator erlaubt eine Änderung der momentanen Betriebsfrequenz auf einfache und schnelle Weise. In einigen bevorzugten Ausführungsbeispielen erzeugt der HF-Signalgenerator das HF-Speisesignal mit einer Betriebsfrequenz, die im unteren Mikrowellenbereich liegt, insbesondere im Bereich von 2 GHz bis 5 GHz. In einem Ausführungsbeispiel liegt die erste Betriebsfrequenz im Bereich von 2,4 GHz bis 2,5 GHz, jeweils einschließlich.

Ausgehend von einer momentanen ersten Betriebsfrequenz, die in einigen Ausführungsbeispielen eine vorab gewählte, nominale Betriebsfrequenz sein kann, testen die beschriebene Vorrichtung und das beschriebene Verfahren eine erhöhte erste Betriebsfrequenz und eine reduzierte erste Betriebsfrequenz in zwei zeitlich aufeinander folgenden Testintervallen, während das HF-Speisesignal weiterhin in das Medium eingekoppelt wird. Die zeitliche Reihenfolge des ersten und zweiten Testintervalls ist prinzipiell frei wählbar. Das bedeutet, dass die definierte erste Betriebsfrequenz in einigen Ausführungsbeispielen zunächst erhöht und zeitlich später reduziert werden kann. In anderen Ausführungsbeispielen kann die definierte erste Betriebsfrequenz hingegen zunächst reduziert und zeitlich später erhöht werden. Dementsprechend implizieren die Bezeichnungen erstes Testintervall und zweites Testintervall hier keine zwingende zeitliche Reihenfolge. Anders ausgedrückt kann das zweite Testintervall zeitlich vor dem ersten Testintervall liegen.

In jedem Fall wird die momentane Betriebsfrequenz des HF-Speisesignals in einem Testzyklus zumindest einmal erhöht und zumindest einmal reduziert. In bevorzugten Ausführungsbeispielen wird die momentane Betriebsfrequenz in einem Testzyklus genau einmal erhöht und zeitlich vorausgehend oder zeitlich nachfolgend genau einmal reduziert. Für jede der drei so erhaltenen Betriebsfrequenzen (momentane erste Betriebsfrequenz, erhöhte erste Betriebsfrequenz und reduzierte erste Betriebsfrequenz) werden zugehörige bzw. zuordenbare HF-Signalreflexionen entlang der Übertragungsstrecke bestimmt. Damit liegen nach einem solchen Test zumindest drei charakteristische Werte für HF-Signalreflexionen vor. Vorteilhaft wird nun sehr einfach diejenige Betriebsfrequenz aus den (drei) genannten Betriebsfrequenzen für den weiteren Betrieb des HF-Signalgenerators ausgewählt, die mit der geringsten HF-Signalreflexion der zumindest drei erfassten HF-Signalreflexionen korreliert.

Die Bestimmung und Auswahl der (zukünftigen) zweiten Betriebsfrequenz ist auf diese Weise sehr einfach und schnell möglich. Insbesondere kann das beschriebene Verfahren ohne Weiteres und sehr vorteilhaft in der Firmware eines HF-Signalgenerators mit einer steuerbaren Betriebsfrequenz implementiert werden. Dementsprechend ist das Erhöhen und Reduzieren der jeweiligen Betriebsfrequenz in zeitlich begrenzten Testintervallen in bevorzugten Ausführungsbeispielen der beschriebenen Vorrichtung in der Firmware eines prozessorgesteuerten HF-Signalgenerators implementiert. Alternativ hierzu könnte die Erhöhung und Reduzierung der ersten Betriebsfrequenz in anderen Ausführungsbeispielen von "extern" erfolgen, d.h. über ein dem HF-Signalgenerator von extern zugeführtes Steuersignal initiiert werden.

Das beschriebene Verfahren und die beschriebene Vorrichtung besitzen den Vorteil, dass die Suche nach einer "besseren" Betriebsfrequenz einerseits auf einen kleinen momentanen Suchbereich beschränkt ist. In den bevorzugten Ausführungsbeispielen ist die Suche nach einer "besseren" Betriebsfrequenz auf genau zwei alternative Werte beschränkt, nämlich einer oberhalb und einer unterhalb der momentanen Betriebsfrequenz. Daher kann diese Suche sehr schnell erfolgen. Andererseits wird bei dem beschriebenen Verfahren und der beschriebenen Vorrichtung "zweiseitig" nach einer eventuell besseren Betriebsfrequenz als der momentanen ersten Betriebsfrequenz gesucht. Daher können das beschriebene Verfahren und die beschriebene Vorrichtung dynamisch wechselnden Impedanzänderungen schnell und richtungsunabhängig, d.h. sowohl zu höheren Impedanzen hin als auch zu geringeren Impedanzen hin, folgen.

Das beschriebene Verfahren und die beschriebene Vorrichtung bieten eine neue Möglichkeit, eine geeignete Betriebsfrequenz für den HF-Signalgenerator sehr einfach und schnell einzustellen. Die oben genannte Aufgabe ist daher vollständig gelöst.

In einer bevorzugten Ausgestaltung der Erfindung wird das Erhöhen und Reduzieren der jeweiligen Betriebsfrequenz zyklisch mit jeweils weiteren Testintervallen wiederholt, wobei die definierte zweite Betriebsfrequenz nach jedem Zyklus als neue erste Betriebsfrequenz verwendet wird.

In dieser Ausgestaltung folgen das beschriebene Verfahren und die beschriebene Vorrichtung dynamisch wechselnden Impedanzänderungen der aufzuheizenden Last im laufenden Betrieb des HF-Signalgenerators. Die jeweils aktuelle Betriebsfrequenz wird adaptiv und dynamisch an wechselnde Impedanzen angepasst. Damit wird eine auf Dauer sehr effiziente Einspeisung der Heizleistung in das Medium erreicht.

In einer weiteren Ausgestaltung erfolgt das Erhöhen und Reduzieren der jeweiligen Betriebsfrequenz zyklisch mit einer Zykluszeit T, die in einem Bereich von 1 ms bis 500 ms liegt, jeweils einschließlich.

Diese Werte haben sich in bevorzugten Ausführungsbeispielen als sehr gut geeignet erwiesen, um dynamisch wechselnde Impedanzen bei einer Plasmalast zu beherrschen, ohne die Erzeugung des Plasmas durch das testweise Erhöhen und Reduzieren der jeweiligen Betriebsfrequenz nachhaltig zu beeinflussen.

In einer weiteren Ausgestaltung besitzt das erste Testintervall eine Intervalllänge, die in einem Bereich von 50 µs bis 500 µs liegt, jeweils einschließlich.

Auch diese Werte haben sich in bevorzugten Ausführungsbeispielen als sehr gut geeignet erwiesen, um dynamisch wechselnde Impedanzen bei einer Plasmalast zu beherrschen, wobei zugleich das Plasma durch konstante Leistungszufuhr aufrechterhalten bleibt.

In einer weiteren Ausgestaltung wird die definierte erste Betriebsfrequenz zu Beginn des ersten Testintervalls sprunghaft um den definierten ersten Frequenzwert erhöht. Vorteilhaft wird die definierte erste Betriebsfrequenz zu Beginn des zweiten Testintervalls sprunghaft reduziert.

Eine jeweils sprunghafte Erhöhung bzw. Reduzierung der ersten Betriebsfrequenz ermöglicht sehr kurze Testintervalle und damit einhergehend eine schnelle und genaue Zuordnung der jeweiligen HF-Signalreflexionen. Alternativ könnte die Erhöhung bzw. Reduzierung der ersten Betriebsfrequenz in anderen Ausgestaltungen mit einem nicht-sprunghaften, mithin eher sanften Übergang erfolgen, was in einigen Szenarien den Vorteil besitzen kann, dass die Plasmaanregung stabiler ist. In vielen Fällen erscheint die sprunghafte Erhöhung bzw. Reduzierung aber aufgrund der minimalen Testzeit vorteilhafter.

In einer weiteren Ausgestaltung sind der definierte erste Frequenzwert und der definierte zweite Frequenzwert gleich.

In dieser Ausgestaltung liegt die erste Betriebsfrequenz mittig zwischen der erhöhten ersten Betriebsfrequenz und der reduzierten ersten Betriebsfrequenz. Die Ausgestaltung besitzt den Vorteil, dass die momentane Betriebsfrequenz des HF-Signalgenerators im zeitlichen Mittel über die Testintervalle hinweg weitgehend konstant bleibt, was ebenfalls vorteilhaft dazu beiträgt, die Plasmaanregung stabil zu halten.

In einer weiteren Ausgestaltung liegt der definierte erste Frequenzwert in einem Bereich von 0,0001% bis 0,001% der definierten ersten Betriebsfrequenz. In einigen Ausführungsbeispielen kann der definierte erste Frequenzwert beispielhaft im Bereich von 5 kHz bis 20 kHz liegen, jeweils einschließlich. In einem vorteilhaften Ausführungsbeispiel ist der erste Frequenzwert 10 kHz bei einer Betriebsfrequenz des HF-Signalgenerators im Bereich von 2,45 GHz.

Ein erster Frequenzwert im 10tel-Promillebereich bezogen auf die nominale Betriebsfrequenz des HF-Signalgenerators ist sehr vorteilhaft, um einerseits die Plasmaerzeugung stabil zu gewährleisten und andererseits gezielt auf Impedanzänderungen der Plasmalast zu reagieren.

In einer weiteren Ausgestaltung schließt das zweite Testintervall unmittelbar an das erste Testintervall an.

In dieser Ausgestaltung geht das zweite Testintervall dem ersten Testintervall unmittelbar voraus oder es folgt dem ersten Testintervall unmittelbar. Dies hat zur Folge, dass die momentane Betriebsfrequenz des HF-Signalgenerators nach einer zeitlich begrenzten Erhöhung (Reduzierung) schnellstmöglich auf den entgegengesetzten Frequenzwert unterhalb (oberhalb) der ursprünglichen ersten Betriebsfrequenz eingestellt wird. In einem Ausführungsbeispiel, in dem der erste Frequenzwert und der zweite Frequenzwert gleich sind, verbleibt die Betriebsfrequenz des HF-Signalgenerators im zeitlichen Mittel über die zwei Testintervalle sehr nah an der ursprünglichen ersten Betriebsfrequenz. In Ausführungsbeispielen, in denen die definierte erste Betriebsfrequenz zu Beginn des ersten Testintervalls sprunghaft um den definierten ersten Frequenzwert erhöht wird und sprunghaft zu Beginn des zweiten Testintervalls reduziert wird, springt die momentane Betriebsfrequenz somit beim Übergang vom ersten Testintervall zum zweiten Testintervall (oder umgekehrt) um den doppelten Frequenzwert. Die Ausgestaltung trägt vorteilhaft dazu bei, die Plasmaanregung über die Testintervalle hinweg sehr stabil zu halten.

In einer weiteren Ausgestaltung wird die definierte erste Betriebsfrequenz bestimmt, indem über die Übertragungsstrecke ein HF-Testsignal mit einer momentanen Betriebsfrequenz übertragen wird, die ein definiertes Frequenzband durchläuft, wobei HF-Signalreflexionen entlang der Übertragungsstrecke bestimmt werden.

In dieser Ausgestaltung wird die erste Betriebsfrequenz, die gewissermaßen den Startwert des beschriebenen Verfahrens bildet, in einem gezielten Suchlauf über das definierte Frequenzband bestimmt. Alternativ hierzu könnte der HF-Signalgenerator anfänglich mit einer nominalen oder einer auf andere Weise ausgewählten Betriebsfrequenz "starten". In einigen Ausführungsbeispielen beinhaltet das definierte Frequenzband die Gesamtbandbreite, die der HF-Signalgenerator in einem definierten Betriebsmodus zur Verfügung stellt. Alternativ oder ergänzend kann das Frequenzband auf Basis gesetzlicher und/oder behördlicher Vorgaben definiert sein und insbesondere sämtliche Frequenzen beinhalten, die für den gewünschten Betrieb und/oder das Aufheizen des gewünschten Mediums sinnvoll und/oder freigegeben sind. In einigen Ausführungsbeispielen deckt das definierte Frequenzband einen Frequenzbereich ab, der in einem Bereich von 2% bis 6%, jeweils einschließlich, der definierten Betriebsfrequenz beinhaltet ist, also z.B. bei einer definierten Betriebsfrequenz von 2,45 GHz in einem Bereich von ca. 50 MHz bis 150 MHz, jeweils einschließlich.

Die Ausgestaltung ergänzt das oben beschriebene Verfahren gewissermaßen um einen "global scan", d.h. eine vorherige und/oder zwischenzeitlich durchgeführte Suche nach einer optimalen Betriebsfrequenz über das definierte Frequenzband. Die Ausgestaltung trägt sehr vorteilhaft dazu bei, die über das zur Verfügung stehende Frequenzband beste Betriebsfrequenz auf einfache und möglichst schnelle Weise zu finden.

In einer weiteren Ausgestaltung wird das HF-Testsignal separat von dem HF-Speisesignal erzeugt über die Übertragungsstrecke übertragen. Vorteilhaft kann das HF-Testsignal in einigen Varianten dieser Ausgestaltung zusätzlich, d.h. zeitlich parallel, zu dem HF-Speisesignal über die Übertragungsstrecke übertragen werden. Alternativ hierzu kann das HF-Testsignal in anderen Ausführungsbeispielen zeitlich getrennt von dem HF-Speisesignal über die Übertragungsstrecke übertragen werden.

Die Ausgestaltung macht es möglich, die Signalreflexionen unabhängig von dem HF-Speisesignal und damit weitgehend unabhängig von dem Aufheizen des Mediums über einen großen Frequenzbereich hinweg zu testen. Daher ermöglicht diese Ausgestaltung eine große Flexibilität, die besonders vorteilhaft ist, wenn sehr verschiedene Medien mit dem HF-Signalgenerator aufgeheizt werden sollen. Die Ausgestaltung beinhaltet auch die Möglichkeit, das HF-Testsignal als Modulationssignal für das HF-Speisesignal zu verwenden und auf diese Weise mit dem HF-Speisesignal zu kombinieren.

In einer weiteren Ausgestaltung bildet das HF-Speisesignal das HF-Testsignal.

In dieser Ausgestaltung wird das HF-Speisesignal zu einem Test-Scan über das definierte Frequenzband verwendet. Dies ermöglicht eine sehr kostengünstige Realisierung.

In einer weiteren Ausgestaltung wird das HF-Testsignal zeitlich vor dem ersten Testintervall erzeugt.

In dieser Ausgestaltung wird der "global scan" vor oder zu Beginn des Aufheizens ausgeführt, um eine anfängliche optimale Betriebsfrequenz als Startpunkt des beschriebenen Verfahrens zu erhalten. Die Ausgestaltung ist recht einfach zu implementieren und ermöglicht eine optimale Betriebsfrequenz bereits zu Beginn des beschriebenen Verfahrens.

In einer weiteren Ausgestaltung wird das HF-Testsignal nach Ablauf des zweiten Testintervalls erneut erzeugt.

In dieser Ausgestaltung wird der "global scan" auch nach Beginn des Aufheizens, mithin also während des Aufheizens einmal oder mehrmals wiederholt ausgeführt. Die Ausgestaltung trägt dazu bei, auch bei sehr starken Änderungen der Lastimpedanz eine jeweils optimale Betriebsfrequenz zu erhalten.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte, schematische Darstellung eines ersten Ausführungsbeispiels der beschriebenen Vorrichtung,
- Fig. 2: eine vereinfachte, schematische Darstellung eines zweiten Ausführungsbeispiels der beschriebenen Vorrichtung, und
- Fig. 3: ein Flussdiagramm zur Erläuterung eines Ausführungsbeispiels des beschriebenen Verfahrens.

Zur besseren Einordnung in das technische Umfeld der Erfindung und der Ausführungsbeispiele dienen auch die im Folgenden zitierten Beschreibungen ähnlicher Verfahren und oder Vorrichtungen:
Die eingangs genannte US 2014/0197761 A1 beschreibt eine Vorrichtung mit einer Vielzahl von Materialbearbeitungsbaugruppen, die parallel zueinander an einen HF-Signalgenerator angeschlossen sind. Die Materialbearbeitungsbaugruppen können beispielsweise Kammern für eine plasmaunterstütze Beschichtung von Werkstücken sein (PVD oder PACVD-Kammern). US 2014/0197761 A1 offenbart, dass jede Materialbearbeitungsbaugruppe eine Messeinrichtung besitzt, mit der die jeweils reflektierte Leistung gemessen wird. In Abhängigkeit von den jeweils gemessenen reflektierten Leistungen soll dann die Betriebsfrequenz des HF-Speisesignals variiert werden, bis ein oder zwei unterschiedlich definierte Schwellenwerte für alle Materialbearbeitungsbaugruppen erreicht werden. US 2014/0197761 A1 offenbart in diesem Zusammenhang, dass die Frequenz des HF-Speisesignals die reflektierte Leistung beeinflusst, und beschreibt insgesamt sechs verschiedene Betriebsmodi, in denen die Frequenz und/oder Leistung des HF-Speisesignals variiert werden, bis die definierten Schwellenwerte erreicht werden.

US 2009/0237170 A1 offenbart ein Verfahren und eine Vorrichtung zum Erzeugen eines Plasmas unter Verwendung eines HF-Signals, wobei die Betriebsfrequenz des HF-Signalgenerators in Abhängigkeit von Impedanzänderungen der Plasmalast und daraus resultierenden Reflexionen variiert wird. Hier soll die optimale Betriebsfrequenz des HF-Signalgenerators gesucht werden, indem die insgesamt verfügbare Bandbreite des Generators in sechzehn Teilbänder unterteilt wird. Im Betrieb soll der HF-Signalgenerator 99% der Zeit mit seiner gewählten Betriebsfrequenz arbeiten. In dem verbleibenden 1% der Zeit soll der Reihe nach in den sechzehn Teilbändern für jeweils kurze Zeit geprüft werden, ob es eine geeignetere Betriebsfrequenz gibt.

DE 10 2011 076 404 B4 beschreibt ein Verfahren zur Anpassung der Ausgangsimpedanz einer Hochfrequenzleistungsversorgungsanordnung an die Impedanz einer Plasmalast. Die Betriebsfrequenz des HF-Signalgenerators wird dahingehend überwacht, ob sie sich in einem vorgegebenen Frequenzbereich befindet. Eine Anpassung wird durch mechanische und/oder elektrische Veränderung einer dem HF-Signalgenerator nachgeschalteten Schaltung erreicht.

In einem White Paper der TRUMPF Hüttinger GmbH + Co. KG aus 79111 Freiburg in Deutschland mit dem Titel "A New Auto Frequency Tuning Algorithm" von Juli 2015 ist offenbart, das HF-Speisesignal eines HF-Generators für eine Plasmalast konstant mit einer Frequenzmodulation zu versehen, um im Betrieb die jeweils beste Betriebsfrequenz zu finden.

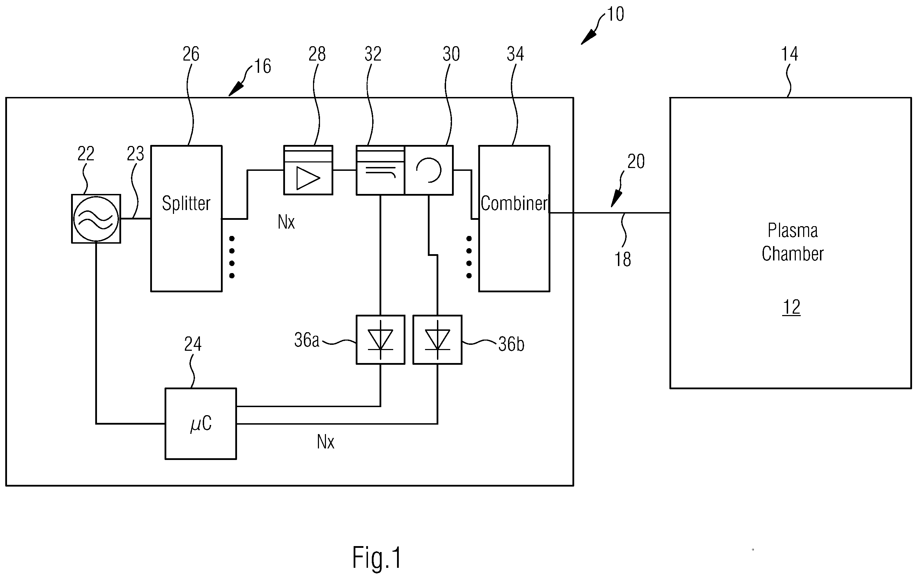

In Fig. 1 ist ein Ausführungsbeispiel der beschriebenen Vorrichtung mit der Bezugsziffer 10 bezeichnet. Die Vorrichtung 10 dient hier zum Aufheizen eines gasförmigen Mediums 12 in einer Plasmakammer 14 (Plasma Chamber), in der beispielsweise Werkstücke (hier nicht dargestellt) mit Hilfe eines Plasmas geätzt und/oder beschichtet werden sollen. Prinzipiell können das beschriebene Verfahren und die beschriebene Vorrichtung aber auch zum Aufheizen von festen und/oder flüssigen Medien verwendet werden, wie dies hinlänglich bei haushaltsüblichen Mikrowellenkochgeräten bekannt ist.

Die Vorrichtung 10 besitzt einen HF-Signalgenerator 16, der ein HF-Speisesignal 18 erzeugt und über eine Übertragungsstrecke 20 in das Medium 12 einkoppelt. Im einfachsten Fall sind in der Plasmakammer 14 Elektroden (hier nicht dargestellt) angeordnet, über die das HF-Speisesignal 18 bspw. in Form einer elektromagnetischen Welle in das Medium 12 eingekoppelt wird.

Der HF-Signalgenerator 16 besitzt in diesem Ausführungsbeispiel einen spannungsgesteuerten Oszillator 22 (VCO), der über einen Mikroprozessor 24 (µC) angesteuert wird und ein Hochfrequenzsignal 23 mit einer Betriebsfrequenz erzeugt, die in Abhängigkeit von der erhaltenen Steuerspannung von dem Mikroprozessor 24 ist. Alternativ oder ergänzend zu dem Mikroprozessor 24 kann der HF-Signalgenerator 16 einen Mikrocontroller und/oder einen anderen Steuerschaltkreis aufweisen, wie etwa einen oder mehrere ASICs, FPGAs oder dergleichen. Die Betriebsfrequenz kann in einigen Ausführungsbeispielen in einem Bereich von 2,4 GHz bis 2,5 GHz liegen.

Das Hochfrequenzsignal 23 ist hier einem Splitter 26 zugeführt, der das Hochfrequenzsignal 23 auf mehrere parallele Signalpfade Nx aufteilt, was in Fig. 1 durch vertikal angeordnete Punkte angedeutet ist. Aus Gründen der Übersichtlichkeit ist hier nur ein einzelner Signalpfad dargestellt. Die parallelen Signalpfade Nx sind in den bevorzugten Ausführungsbeispielen jeweils gleich aufgebaut und besitzen dieselben Elemente. Insbesondere enthält jeder der parallelen Signalpfade Nx einen Signalverstärker 28, der den entsprechenden Signalanteil des Hochfrequenzsignals 23 in dem Signalpfad Nx verstärkt. Des Weiteren enthält hier jeder der parallelen Signalpfade Nx einen Zirkulator 30 und einen Richtkoppler 32, der dem Zirkulator 30 hier in Vorwärtsrichtung zu der Plasmakammer 14 vorgeschaltet ist.

Die in den parallelen Signalpfaden Nx jeweils verstärkten Signalanteile des Hochfrequenzsignals 23 werden hier mit einem Koppler 34 (Combiner) zusammengeführt. Vorzugsweise werden die verstärkten Signalanteile des Hochfrequenzsignals 23 in dem Combiner 34 phasenrichtig zusammengeführt. Der Koppler 34 (Combiner) erzeugt damit aus den einzeln verstärkten Signalanteilen des Hochfrequenzsignals 23 das leistungsstarke HF-Speisesignal 18. Die Aufteilung des Hochfrequenzsignals 23 auf parallele Signalpfade Nx mit jeweils zumindest einem Signalverstärker 28 und die nachfolgende Zusammenführung in dem Combiner 34 erleichtert eine hohe Leistungsverstärkung des ursprünglichen Hochfrequenzsignals 23 in bevorzugten Ausführungsbeispielen. Prinzipiell können das beschriebene Verfahren und die entsprechende Vorrichtung aber auch mit einem einzelnen Signalverstärkungspfad realisiert sein.

Der Richtkoppler 32 in jedem Signalpfad Nx ist hier in an sich bekannter Weise dazu eingerichtet, einen kleinen Signalanteil des zur Plasmakammer 14 hinlaufenden HF-Signals 18 auszukoppeln und über einen Gleichrichter 36a dem Mikroprozessor 24 zuzuführen. Der Zirkulator 30 in jedem Signalpfad Nx ist hier dazu eingerichtet, eine Signalreflexion (typischerweise in Form einer zurücklaufenden Welle, hier nicht dargestellt) abzuleiten. In dem hier dargestellten Ausführungsbeispiel leitet der Zirkulator 30 in jedem Signalpfad Nx zur Messung einen kleinen Teil der zurücklaufenden Signalreflexion über einen weiteren Gleichrichter 36b zu dem Mikroprozessor 24.

Der Zirkulator 30 in jedem Signalpfad Nx dient hier einerseits dazu, die zurücklaufende Signalreflexion von dem Verstärker 27, dem Oszillator 22 und anderen empfindlichen Komponenten des HF-Signalgenerators 16 fernzuhalten. Darüber hinaus wirkt der Zirkulator 30 in jedem Signalpfad Nx hier auch ähnlich wie der Richtkoppler 32, indem er zur Messung einen kleinen Teil der zurücklaufenden Signalreflexion dem Mikroprozessor 24 zuführt.

Der Mikroprozessor 24 kann in bevorzugten Ausführungsbeispielen einen oder mehrere Analog-Digital-Wandler (hier nicht dargestellt) beinhalten oder mit einem oder mehreren vorgeschalteten Analog-Digital-Wandlern (hier nicht dargestellt) kombiniert sein. Der oder die Analog-Digital-Wandler ist/sind vorteilhaft dazu eingerichtet, die über die Richtkoppler 32 ausgekoppelten Signalanteile der hinlaufenden Leistung und die mit dem Zirkulator 30 abgeleitete zurücklaufende Leistung in digitale Werte umzuwandeln und somit für eine digitale Signalverarbeitung im Mikroprozessor 24 zur Verfügung zu stellen.

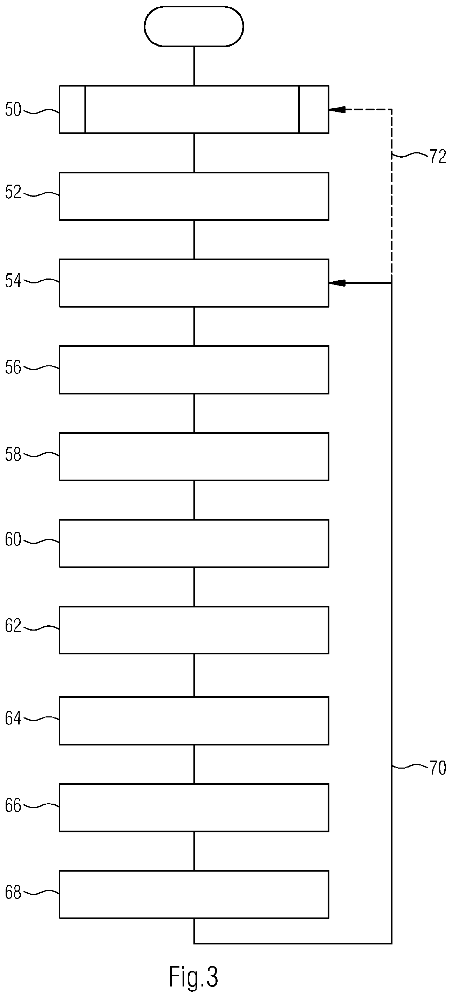

Im Betrieb der Vorrichtung 10 bestimmt der Mikroprozessor 24 mit Hilfe der von den parallelen Zirkulatoren 30 erhaltenen Leistungen die jeweilige HF-Signalreflexion auf der Übertragungsstrecke 18 und variiert in Abhängigkeit davon die Betriebsfrequenz des spannungsgesteuerten Oszillators 22, um die HF-Signalreflexion auf der Übertragungsstrecke 18 zu reduzieren. Dabei kann der Mikroprozessor 24 das in Fig. 3 vereinfacht dargestellte Verfahren implementieren.

Zunächst kann in einigen Ausführungsbeispielen der optionale Schritt 50 ausgeführt werden. Hier wird das zur Verfügung stehende Frequenzband mit Hilfe eines HF-Testsignals, das der Mikroprozessor 24 mit Hilfe des Oszillators 22 erzeugen kann, sequentiell abgescannt, um eine vorteilhafte erste Betriebsfrequenz zum Aufheizen des Mediums 12 zu finden. Alternativ hierzu kann eine nominale erste Betriebsfrequenz anhand von theoretischen Überlegungen und/oder anhand von praktischen Erfahrungswerten gewählt werden.

Gemäß Schritt 52 wird dann das HF-Speisesignal mit der ersten Betriebsfrequenz erzeugt und gemäß Schritt 54 in das Medium eingekoppelt. Gemäß Schritt 56 wird eine erste HF-Signalreflexion auf der Übertragungsstrecke 20 bestimmt. Dies kann entsprechend Fig. 1 vorteilhaft unter Verwendung des Zirkulators 30 in jedem Signalpfad Nx und unter Verwendung des Mikroprozessors 24 oder alternativ mit Hilfe einer anderen, ggf. analogen Leistungsmesseinrichtung (hier nicht dargestellt) geschehen. Gemäß Schritt 58 wird die Betriebsfrequenz des HF-Speisesignals hier dann während eines ersten Testintervalls um einen definierten Frequenzwert fstep erhöht und es wird gemäß Schritt 60 eine zweite HF-Signalreflexion auf der Übertragungsstrecke 20 bestimmt. Die zweite HF-Signalreflexion korreliert zeitlich mit der um fstep erhöhten Betriebsfrequenz des HF-Speisesignals. Gemäß Schritt 62 wird die Betriebsfrequenz des HF-Speisesignals hier dann während eines zweiten Testintervalls um das Doppelte des definierten Frequenzwerts fstep reduziert, so dass die Betriebsfrequenz des HF-Speisesignals in dem zweiten Testintervall um einen zweiten Frequenzwert, der hier dem ersten Frequenzwert fstep entspricht, reduziert ist. Gemäß Schritt 64 wird eine dritte HF-Signalreflexion auf der Übertragungsstrecke 20 bestimmt, die zeitlich mit der reduzierten Betriebsfrequenz des HF-Speisesignals korreliert. Gemäß Schritt 66 wird nun bestimmt, welche der drei erhaltenen Signalreflexionen die geringste war und die zukünftige Betriebsfrequenz des HF-Speisesignal wird gemäß Schritt 68 auf diejenige (zweite) Betriebsfrequenz aus dem Tripel "erste Betriebsfrequenz, erhöhte erste Betriebsfrequenz, reduzierte erste Betriebsfrequenz" eingestellt, die mit der geringsten Signalreflexion korreliert.

In den bevorzugten Ausführungsbeispielen fungiert die nun eingestellte zweite Betriebsfrequenz gemäß Schleife 70 als neue erste Betriebsfrequenz, d.h. die Schritte 54 bis 68 werden zyklisch wiederholt, während das HF-Speisesignal in das Medium eingekoppelt wird.

In einigen Ausführungsbeispielen kann zudem der Schritt 50 gemäß Schleife 72 zyklisch wiederholt werden, wobei die Zykluszeit der Schleife 72 vorteilhaft größer gewählt wird als die Zykluszeit der Schleife 70. Insbesondere kann der Global Scan des Frequenzbandes gemäß Schritt 50 mit einer Zykluszeit wiederholt werden, die ein 10faches, 100faches oder gar 1000faches der Zykluszeit gemäß Schleife 70 beträgt.

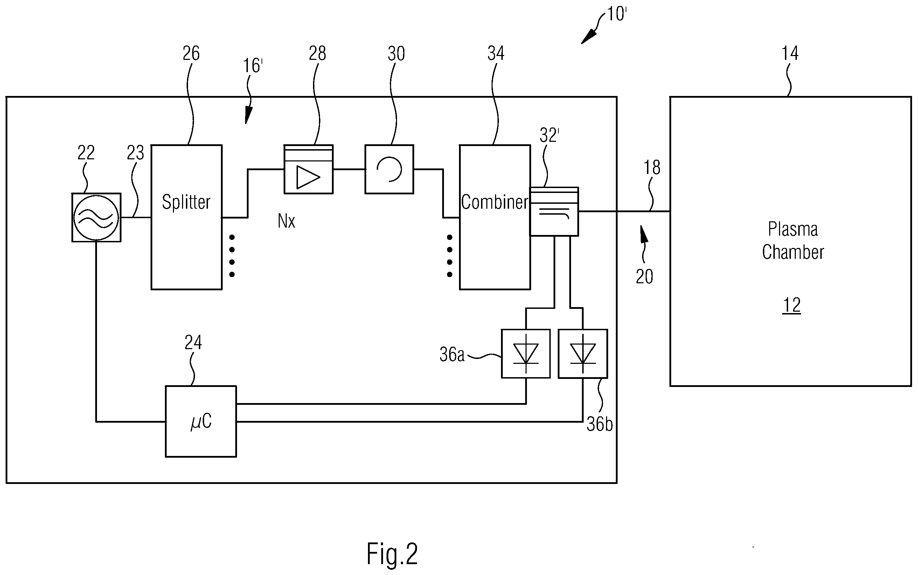

In Fig. 2 ist ein weiteres Ausführungsbeispiel einer Vorrichtung 10' dargestellt, mit der das beschriebene Verfahren vorteilhaft implementiert werden kann. Gleiche Bezugszeichen bezeichnen dieselben Elemente wir zuvor.

In dem Ausführungsbeispiel gemäß Fig. 2 ist ein gemeinsamer Richtkoppler 32' für mehrere oder alle parallelen Signalpfade Nx am Ausgang des Combiners 34 angeordnet. Damit können die Richtkoppler 32 in den parallelen Signalpfaden Nx aus Fig. 1 entfallen. Der Richtkoppler 32' ist vorteilhaft dazu eingerichtet, sowohl einen Anteil der hinlaufenden Leistung als auch einen Anteil der zurücklaufenden Leistung zur Bestimmung der HF-Signalreflexion auszukoppeln. Das Ausführungsbeispiel gemäß Fig. 2 kommt daher mit einer geringeren Anzahl an Richtkopplern aus. Die Zirkulatoren 30 in den parallelen Signalpfaden Nx dienen hier lediglich dazu, eine verbleibende Signalreflexion in eine sogenannte Dummy Load (hier nicht dargestellt) abzuleiten. Die Dummy Load ist eine Last, die in erster Linie dazu dient, die Leistung einer Signalreflexion aufzunehmen und in Wärme umzuwandeln (zu "vernichten").

## Patentansprüche

1. Verfahren zum Erhitzen eines Mediums (12), insbesondere zum Erzeugen eines Plasmas, unter Verwendung eines HF-Signals, mit den Schritten:
- Erzeugen (52) eines HF-Speisesignals (18) mit einer definierten ersten Betriebsfrequenz und einer definierten ersten Signalleistung,
- Einkoppeln (54) des HF-Speisesignals (18) in das Medium (12) über eine Übertragungsstrecke (20), so dass das Medium (12) durch das HF-Speisesignal (18) aufgeheizt wird,
- Bestimmen (56) einer ersten HF-Signalreflexion entlang der Übertragungsstrecke (18), und
- Verändern (68) der ersten Betriebsfrequenz in Abhängigkeit von der ersten HF-Signalreflexion, um zeitlich nachfolgende HF-Signalreflexionen zu reduzieren,
**dadurch gekennzeichnet, dass** die definierte erste Betriebsfrequenz während eines ersten Testintervalls um einen definierten ersten Frequenzwert verändert, insbesondere erhöht (58), wird, um das erste HF-Speisesignal zeitlich begrenzt mit einer veränderten, insbesondere erhöhten, ersten Betriebsfrequenz in das Medium (12) einzukoppeln, und dass die definierte erste Betriebsfrequenz während eines zweiten Testintervalls um einen definierten zweiten Frequenzwert in umgekehrter Weise verändert, insbesondere reduziert (62), wird, um das erste HF-Speisesignal zeitlich begrenzt mit einer in umgekehrter Weise veränderten, insbesondere reduzierten, ersten Betriebsfrequenz in das Medium (12) einzukoppeln,
wobei während des ersten Testintervalls eine zweite HF-Signalreflexion bestimmt (60) wird, die zeitlich mit der veränderten, insbesondere erhöhten, ersten Betriebsfrequenz korreliert, und wobei während des zweiten Testintervalls eine dritte HF-Signalreflexion bestimmt (64) wird, die zeitlich mit der in umgekehrter Weise veränderten, insbesondere reduzierten, ersten Betriebsfrequenz korreliert, und
wobei das HF-Speisesignal nach Ablauf des zweiten Testintervalls mit einer definierten zweiten Betriebsfrequenz erzeugt (68) und in das Medium (12) eingekoppelt wird,
wobei die definierte zweite Betriebsfrequenz in Abhängigkeit von der ersten, zweiten und dritten HF-Signalreflexion ausgewählt (66) wird.

2. Verfahren nach Anspruch 1, **dadurch gekennzeichnet, dass** das Erhöhen und Reduzieren der jeweiligen Betriebsfrequenz zyklisch mit jeweils weiteren Testintervallen wiederholt (70) wird, wobei die definierte zweite Betriebsfrequenz nach jedem Zyklus als neue erste Betriebsfrequenz verwendet wird.

3. Verfahren nach Anspruch 1 oder 2, **dadurch gekennzeichnet, dass** das Erhöhen und Reduzieren der jeweiligen Betriebsfrequenz zyklisch mit einer Zykluszeit (T) erfolgt, die in einem Bereich von 1 ms bis 500 ms liegt, jeweils einschließlich.

4. Verfahren nach einem der Ansprüche 1 bis 3, **dadurch gekennzeichnet, dass** das erste Testintervall eine Intervalllänge besitzt, die in einem Bereich von 50 µs bis 500 µs liegt, jeweils einschließlich.

5. Verfahren nach einem der Ansprüche 1 bis 4, **dadurch gekennzeichnet, dass** die definierte erste Betriebsfrequenz zu Beginn des ersten Testintervalls sprunghaft um den definierten ersten Frequenzwert erhöht wird.

6. Verfahren nach einem der Ansprüche 1 bis 5, **dadurch gekennzeichnet, dass** der definierte erste Frequenzwert und der definierte zweite Frequenzwert gleich sind.

7. Verfahren nach einem der Ansprüche 1 bis 6, **dadurch gekennzeichnet, dass** der definierte erste Frequenzwert in einem Bereich von 0,0001% bis 0,001% der definierten ersten Betriebsfrequenz liegt.

8. Verfahren nach einem der Ansprüche 1 bis 7, **dadurch gekennzeichnet, dass** das zweite Testintervall unmittelbar an das erste Testintervall anschließt.

9. Verfahren nach einem der Ansprüche 1 bis 8, **dadurch gekennzeichnet, dass** die definierte erste Betriebsfrequenz bestimmt wird, indem über die Übertragungsstrecke ein HF-Testsignal mit einer momentanen Betriebsfrequenz übertragen (50) wird, die ein definiertes Frequenzband durchläuft, wobei HF-Signalreflexionen entlang der Übertragungsstrecke (20) bestimmt werden.

10. Verfahren nach Anspruch 9, **dadurch gekennzeichnet, dass** das HF-Testsignal separat von dem HF-Speisesignal erzeugt und über die Übertragungsstrecke (20) übertragen wird.

11. Verfahren nach Anspruch 9, **dadurch gekennzeichnet, dass** das HF-Speisesignal (18) das HF-Testsignal bildet.

12. Verfahren nach einem der Ansprüche 9 bis 11, **dadurch gekennzeichnet, dass** das HF-Testsignal zeitlich vor dem ersten Testintervall erzeugt wird.

13. Verfahren nach einem der Ansprüche 9 bis 12, **dadurch gekennzeichnet, dass** das HF-Testsignal nach Ablauf des zweiten Testintervalls erneut erzeugt (72) wird.

14. Vorrichtung zum Erhitzen eines Mediums (12) , insbesondere zum Erzeugen eines Plasmas, unter Verwendung eines HF-Signals mit
- einem HF-Generator (16, 16'), der dazu eingerichtet ist, ein HF-Speisesignal 818) mit einer definierten ersten Betriebsfrequenz und einer definierten ersten Signalleistung zu erzeugen,
- einer Übertragungsstrecke (20), die dazu eingerichtet ist, das HF-Speisesignal (18) in das Medium (12) einzukoppeln, so dass das Medium (12) durch das HF-Speisesignal (18) aufgeheizt werden kann, und
- einer Mess- und Steuereinrichtung (24, 32, 36), die dazu eingerichtet ist, eine erste HF-Signalreflexion entlang der Übertragungsstrecke (20) zu bestimmen, und die ferner dazu eingerichtet ist, die erste Betriebsfrequenz in Abhängigkeit von der ersten HF-Signalreflexion zu verändern, um zeitlich nachfolgende HF-Signalreflexionen zu reduzieren,
**dadurch gekennzeichnet, dass** die Mess- und Steuereinrichtung (24, 32, 36) ferner dazu eingerichtet ist,
die definierte erste Betriebsfrequenz während eines ersten Testintervalls um einen definierten ersten Frequenzwert zu verändern, insbesondere zu erhöhen (58), um das erste HF-Speisesignal zeitlich begrenzt mit einer veränderten, insbesondere erhöhten, ersten Betriebsfrequenz in das Medium (12) einzukoppeln,
die definierte erste Betriebsfrequenz während eines zweiten Testintervalls um einen definierten zweiten Frequenzwert in umgekehrter Weise zu verändern, insbesondere zu reduzieren (62), um das erste HF-Speisesignal zeitlich begrenzt mit einer in umgekehrter Weise veränderten, insbesondere reduzierten, ersten Betriebsfrequenz in das Medium (12) einzukoppeln,
während des ersten Testintervalls eine zweite HF-Signalreflexion zu bestimmen (60), die zeitlich mit der veränderten, insbesondere erhöhten, ersten Betriebsfrequenz korreliert,
während des zweiten Testintervalls eine dritte HF-Signalreflexion zu bestimmen (64), die zeitlich mit der in umgekehrter Weise veränderten, insbesondere reduzierten ersten Betriebsfrequenz korreliert, und
das HF-Speisesignal nach Ablauf des zweiten Testintervalls mit einer definierten zweiten Betriebsfrequenz zu erzeugen (68) und in das Medium (12) einzukoppeln, wobei die definierte zweite Betriebsfrequenz in Abhängigkeit von der ersten, zweiten und dritten HF-Signalreflexion ausgewählt (66) ist.

## Claims

1. A method for heating a medium (12), in particular for generating a plasma, using an HF signal, with the steps:
- generating (52) an HF supply signal (18) with a defined first operating frequency and a defined first signal power,
- coupling (54) the HF supply signal (18) into the medium (12) via a transmission path (20) so that the medium (12) is heated by the HF supply signal (18),
- determining (56) a first HF signal reflection along the transmission path (18), and
- changing (68) the first operating frequency depending on the first HF signal reflection in order to reduce subsequent HF signal reflections,
**characterized in that** the defined first operating frequency is changed, in particular increased (58), by a defined first frequency value during a first test interval in order to couple the first HF supply signal into the medium (12) with a changed, in particular increased, first operating frequency for a limited time, and that the defined first operating frequency is changed in the reverse manner, in particular reduced (62), by a defined second frequency value during a second test interval in order to couple the first HF supply signal into the medium (12) for a limited time with a first operating frequency that has been changed in the reverse manner, in particular reduced,
wherein a second HF signal reflection is determined (60) during the first test interval, which correlates in time with the changed, in particular increased, first operating frequency, and wherein a third HF signal reflection is determined (64) during the second test interval, which correlates in time with the first operating frequency, which has been changed in the reverse manner, in particular reduced, and
wherein the HF supply signal is generated (68) at a defined second operating frequency after the second test interval has elapsed and is coupled into the medium (12),
wherein the defined second operating frequency is selected (66) as a function of the first, second and third HF signal reflections.

2. The method according to claim 1, **characterized in that** increasing and reducing the respective operating frequency is cyclically repeated (70) with further respective test intervals, wherein the defined second operating frequency is used as the new first operating frequency after each cycle.

3. The method according to claim 1 or 2, **characterized in that** increasing and reducing the respective operating frequency is carried out cyclically with a cycle time (T) which lies in a range between and including 1 ms and 500 ms, respectively.

4. The method according to one of claims 1 to 3, **characterized in that** the first test interval has an interval length which lies in an area between and including 50 µs and 500 µs, respectively.

5. The method according to any one of claims 1 to 4, **characterized in that** the defined first operating frequency is suddenly increased by the defined first frequency value at the start of the first test interval.

6. The method according to any one of claims 1 to 5, **characterized in that** the defined first frequency value and the defined second frequency value are the same.

7. The method according to any one of claims 1 to 6, **characterized in that** the defined first frequency value is in a range between 0.0001% and 0.001% of the defined first operating frequency.

8. The method according to any one of claims 1 to 7, **characterized in that** the second test interval immediately follows the first test interval.

9. The method according to any one of claims 1 to 8, **characterized in that** the defined first operating frequency is determined by transmitting (50) an HF test signal over the transmission path at an instantaneous operating frequency which passes through a defined frequency band, wherein HF signal reflections along the transmission path (20) are determined.

10. The method according to claim 9, **characterized in that** the HF test signal is generated separately from the HF supply signal and is transmitted via the transmission path (20).

11. The method according to claim 9, **characterized in that** the HF supply signal (18) forms the HF test signal.

12. The method according to any one of claims 9 to 11, **characterized in that** the HF test signal is generated temporally before the first test interval.

13. The method according to any one of claims 9 to 12, **characterized in that** the HF test signal is generated again (72) after the second test interval has elapsed.

14. An apparatus for heating a medium (12), in particular for generating a plasma, using an HF signal, with
- an HF generator (16, 16') configured to generate an HF supply signal 818) with a defined first operating frequency and a defined first signal power,
- a transmission path (20) configured to couple the HF supply signal (18) into the medium (12) so that the medium (12) can be heated by the HF supply signal (18), and
- a measuring and control device (24, 32, 36) configured to determine a first HF signal reflection along the transmission path (20) and further configured to change the first operating frequency as a function of the first HF signal reflection in order to reduce subsequent HF signal reflections,
**characterized in that** the measuring and control device (24, 32, 36) is further configured to
change the defined first operating frequency during a first test interval by a defined first frequency value, in particular increase (58) it, in order to couple the first HF supply signal into the medium (12) for a limited time with a changed, in particular increased, first operating frequency,
change the defined first operating frequency during a second test interval by a defined second frequency value in the reverse manner, in particular reduce (62) it, in order to couple the first HF supply signal into the medium (12) for a limited time with a changed, in particular reduced, first operating frequency in the reverse manner,
determine (60) a second HF signal reflection during the first test interval, which correlates in time with the changed, in particular increased, first operating frequency,
determine (64) a third HF signal reflection during the second test interval, which correlates in time in the reverse manner with the changed, in particular reduced, first operating frequency, and
generate (68) the HF supply signal after the second test interval has elapsed with a defined second operating frequency and couple it into the medium (12), wherein the defined second operating frequency is selected (66) as a function of the first, second and third HF signal reflections.

## Revendications

1. Procédé de chauffage d'un fluide (12), en particulier pour générer un plasma, à l'aide d'un signal HF, comprenant les étapes suivantes :
- génération (52) d'un signal d'alimentation HF (18) avec une première fréquence de fonctionnement définie et une première puissance de signal définie,
- couplage (54) du signal d'alimentation HF (18) au fluide (12) sur un trajet de transmission (20) de sorte que le fluide (12) est chauffé par le signal d'alimentation HF (18),
- détermination (56) d'une première réflexion de signal HF le long du trajet de transmission (18), et
- modification (68) de la première fréquence de fonctionnement en fonction de la première réflexion de signal HF afin de diminuer les réflexions de signal HF ultérieures,
**caractérisé en ce que** la première fréquence de fonctionnement définie est modifiée, en particulier augmentée (58), d'une première valeur de fréquence définie pendant un premier intervalle de test afin de coupler le premier signal d'alimentation HF dans le fluide (12) pendant une durée limitée à une première fréquence de fonctionnement modifiée, en particulier augmentée, et **en ce que** la première fréquence de fonctionnement définie est modifiée, en particulier diminuée (62), en sens inverse d'une deuxième valeur de fréquence définie pendant un deuxième intervalle de test afin de coupler le premier signal d'alimentation HF dans le fluide (12) pendant une durée limitée à une première fréquence de fonctionnement modifiée, en particulier diminuée, en sens inverse,
dans lequel, pendant le premier intervalle de test, une deuxième réflexion de signal HF est déterminée (60), qui est en corrélation temporelle avec la première fréquence de fonctionnement modifiée, en particulier augmentée, et dans lequel, pendant le deuxième intervalle de test, une troisième réflexion de signal HF est déterminée (64), qui est en corrélation temporelle avec la première fréquence de fonctionnement modifiée, en particulier diminuée, en sens inverse, et
dans lequel le signal d'alimentation HF est généré (68) avec une deuxième fréquence de fonctionnement définie après l'expiration du deuxième intervalle de test et est couplé au fluide (12),
dans lequel la deuxième fréquence de fonctionnement définie est sélectionnée (66) en fonction des première, deuxième et troisième réflexions de signal HF.

2. Procédé selon la revendication 1, **caractérisé en ce que** l'augmentation/diminution de la fréquence de fonctionnement respective est répétée cycliquement (70) avec d'autres intervalles de test respectifs, dans lequel la deuxième fréquence de fonctionnement définie est utilisée comme nouvelle première fréquence de fonctionnement après chaque cycle.

3. Procédé selon la revendication 1 ou 2, **caractérisé en ce que** l'augmentation/diminution de la fréquence de fonctionnement respective s'effectue de manière cyclique avec une période de cycle (T) comprise dans une plage de 1 ms à 500 ms, ces valeurs incluses.

4. Procédé selon l'une des revendications 1 à 3, **caractérisé en ce que** le premier intervalle de test présente une longueur d'intervalle comprise dans une plage de 50 µs à 500 µs, ces valeurs incluses.

5. Procédé selon l'une des revendications 1 à 4, **caractérisé en ce que** la première fréquence de fonctionnement définie est augmentée brusquement de la première valeur de fréquence définie au début du premier intervalle de test.

6. Procédé selon l'une des revendications 1 à 5, **caractérisé en ce que** la première valeur de fréquence définie et la deuxième valeur de fréquence définie sont égales.

7. Procédé selon l'une des revendications 1 à 6, **caractérisé en ce que** la première valeur de fréquence définie est comprise dans une plage de 0,0001 % à 0,001 % de la première fréquence de fonctionnement définie.

8. Procédé selon l'une des revendications 1 à 7, **caractérisé en ce que** le deuxième intervalle de test suit immédiatement le premier intervalle de test.

9. Procédé selon l'une des revendications 1 à 8, **caractérisé en ce que** la première fréquence de fonctionnement définie est déterminée en émettant (50) un signal de test HF avec une fréquence de fonctionnement actuelle sur le trajet de transmission qui parcourt une bande de fréquence définie, dans lequel les réflexions du signal HF le long du trajet de transmission (20) sont déterminées.

10. Procédé selon la revendication 9, **caractérisé en ce que** le signal de test HF est généré séparément du signal d'alimentation HF et transmis sur le trajet de transmission (20).

11. Procédé selon la revendication 9, **caractérisé en ce que** le signal d'alimentation HF (18) forme le signal de test HF.

12. Procédé selon l'une des revendications 9 à 11, **caractérisé en ce que** le signal de test HF est généré avant le premier intervalle de test.

13. Procédé selon l'une des revendications 9 à 12, **caractérisé en ce que** le signal de test HF est généré à nouveau (72) après l'expiration du deuxième intervalle de test.

14. Dispositif de chauffage d'un fluide (12), en particulier pour générer un plasma, à l'aide d'un signal HF, comprenant
- un générateur HF (16, 16') configuré pour générer un signal d'alimentation HF 818) ayant une première fréquence de fonctionnement définie et une première puissance de signal définie,
- un trajet de transmission (20) configuré pour coupler le signal d'alimentation HF (18) au fluide (12) de sorte que le fluide (12) peut être chauffé par le signal d'alimentation HF (18), et
- un dispositif de mesure et de contrôle (24, 32, 36) configuré pour déterminer une première réflexion de signal HF le long du trajet de transmission (20), et configuré en outre pour modifier la première fréquence de fonctionnement en fonction de la première réflexion de signal HF afin de diminuer les réflexions de signal HF ultérieures,
**caractérisé en ce que** le dispositif de mesure et de contrôle (24, 32, 36) est en outre configuré pour
modifier, en particulier augmenter (58), la première fréquence de fonctionnement définie d'une première valeur de fréquence définie pendant un premier intervalle de test afin de coupler le premier signal d'alimentation HF dans le fluide (12) pendant une durée limitée à une première fréquence de fonctionnement modifiée, en particulier augmentée,
modifier, en particulier diminuer (62), en sens inverse la première fréquence de fonctionnement définie d'une deuxième valeur de fréquence définie pendant un deuxième intervalle de test afin de coupler le premier signal d'alimentation HF dans le fluide (12) pendant une durée limitée à une première fréquence de fonctionnement modifiée, en particulier diminuée, en sens inverse,
déterminer (60) pendant le premier intervalle de test une deuxième réflexion de signal HF qui est corrélée dans le temps avec la première fréquence de fonctionnement modifiée, en particulier augmentée,
déterminer (64) pendant le deuxième intervalle de test une troisième réflexion de signal HF qui est corrélée dans le temps avec la première fréquence de fonctionnement modifiée, en particulier diminuée, en sens inverse, et
générer (68) le signal d'alimentation HF après expiration du deuxième intervalle de test à une deuxième fréquence de fonctionnement définie et le coupler dans le fluide (12), dans lequel la deuxième fréquence de fonctionnement définie est sélectionnée (66) en fonction des première, deuxième et troisième réflexions du signal HF.
